# EUROPEAN PATENT APPLICATION

(11) **EP 4 796 939 A1**
(43) Date of publication of application: **26.08.2026**
(21) Application number: 24879536.1
(22) Date of filing: 30.09.2024
(51) Int. Cl.: G01R 31/367, G01R 31/388, G01R 31/3835, H01M 10/48, H02J 7/00

(54) **BATTERY STATE ESTIMATION SYSTEM, BATTERY STATE ESTIMATION METHOD, BATTERY STATE ESTIMATION PROGRAM, AND RECORDING MEDIUM**

(30) Priority: 16.10.2023 JP 2023178232
(71) Applicant: Panasonic Intellectual Property Management Co., Ltd., Kadoma-shi, Osaka 571-0057 (JP)
(72) Inventor: TANIKAWA, Masahiro, Kadoma-shi, Osaka 571-0057 (JP)
(74) Representative: Novagraaf International SA
(86) International application number: PCT/JP2024/034869
(87) International publication number: WO 2025/084110

(57) **Abstract**

A battery model generation unit generates an internal model including the open circuit voltage (OCV) based on measured values of the terminal voltages of the battery at a plurality of time points during a rest period after charge and discharge of the battery. The prediction unit predicts, based on the generated internal model of the battery, the terminal voltage of the battery and the OCV of the battery at a time point after the elapse of a first set period. In a case where the error between the predicted value and the measured value of the terminal voltage of the battery at the time point after the elapse of the first set period from the time point of the prediction is less than a certain value, the battery state estimation unit determines the OCV predicted based on the internal model of the battery as the estimated value of the OCV of the battery.

## Description

### TECHNICAL FIELD

The present disclosure relates to a battery state estimation system for estimating an internal state of a battery, a battery state estimation method, a battery state estimation program, and a recording medium.

### BACKGROUND ART

In order to estimate an internal state of a battery such as a state of charge (SOC), a full charge capacity (FCC), and a state of health (SOH) with high accuracy, it is necessary to estimate an open circuit voltage (OCV) of the battery with high accuracy as a premise.

PTL 1 discloses a method for estimating an OCV without waiting for stabilization of a terminal voltage of a battery after switching from an energization period to a non-energization period. In Fig. 6 of PTL 1, charge and discharge of battery unit 31 are stopped in non-energization period P2 from time t_{C} to time t_{D}. Time t_{C1} belongs to non-energization period P2 and is set to a time after a predetermined time from time t_{C}. Time t_{C2} belongs to non-energization period P2 and is set to a time later than time t_{C1}. The OCV at time t during non-energization period P2 is estimated by Equations (8) and (9). The time difference between time t_{C1} and time t_{C2} is substituted into t on the right side of Equation (8). PTL 1 describes that the required estimation time for the OCV can be shortened by estimating the OCV based on Equations (8) and (9). However, a specific setting method of time t_{C2} as the end point of the required estimation time is not mentioned.

### Citation List

### Patent Literature

PTL 1: International Publication No. 13/141100

### SUMMARY OF THE INVENTION

If the time required for OCV estimation is set to be longer than the minimum time actually required, user convenience is deteriorated. Specifically, this causes a delay in subsequent processing (such as SOC calculation processing) and a delay in the charge/discharge schedule. On the other hand, if the time is set shorter than the actually necessary minimum time, the OCV estimation accuracy is deteriorated.

The present disclosure has been made in view of such a situation, and an object of the present disclosure is to provide a technology for shortening an OCV estimation time while ensuring a certain estimation accuracy.

In order to solve the above problem, a battery state estimation system according to an aspect of the present disclosure includes a battery model generation unit that generates an internal model of a battery including an open circuit voltage (OCV) based on measured values of a terminal voltage of the battery at a plurality of time points during a rest period after charge and discharge of the battery, a prediction unit that predicts, based on the generated internal model of the battery, a terminal voltage of the battery and an OCV of the battery at a time point after an elapse of a first set period from a time point of prediction, and an OCV estimation unit that determines the OCV predicted based on the internal model of the battery as an estimated value of the OCV of the battery in a case where an error between a predicted value and a measured value of a terminal voltage of the battery at the time point after the elapse of the first set period from the time point of the prediction is less than a certain value.

Any combinations of the configuration elements described above and equations of the present disclosure that are converted in terms of devices, systems, methods, computer programs, and the like are also effective as aspects of the present disclosure.

According to the present disclosure, it is possible to shorten the OCV estimation time while securing a certain estimation accuracy.

### BRIEF DESCRIPTION OF THE DRAWINGS

Fig. 1 is a diagram for explaining a battery-mounted device according to an exemplary embodiment.
Fig. 2 is a diagram illustrating a configuration example of a battery state estimation system according to the exemplary embodiment.
Fig. 3 is a diagram illustrating an example of an equivalent circuit model of each cell constituting an assembled battery in a battery pack.
Fig. 4 is a diagram illustrating a transition image of a terminal voltage of a cell during a rest period after discharge stop.
Fig. 5 is a flowchart illustrating a flow of OCV estimation processing performed by the battery state estimation system according to the exemplary embodiment.
Fig. 6A is a diagram illustrating a transition example of an SOC of a battery pack mounted on a battery-mounted device.
Fig. 6B is a diagram illustrating a transition example of the SOC of the battery pack mounted on the battery-mounted device.
Fig. 7 is a diagram illustrating an example setting of second set period Δt during a rest period after discharge.
Fig. 8 is a diagram illustrating an example setting of first set period Δs during a rest period after discharge.
Fig. 9 is a diagram illustrating an example in which first set period Δs is set shorter than second set period Δt during a rest period after discharge.
Fig. 10 is a diagram illustrating an example in which first set period Δs is set to be longer than second set period Δt during a rest period after discharge.
Fig. 11 is a diagram illustrating an example in which first set period Δs and second set period Δt are set equal during a rest period after discharge.
Fig. 12 is a diagram illustrating an example of evaluating accuracy of an OCV predicted value based on a prediction error between a predicted value and a measured value of a terminal voltage at a final point within first set period Δs in a rest period after discharge.
Fig. 13 is a diagram illustrating an example of evaluating accuracy of an OCV predicted value based on a prediction error between a predicted value and a measured value of a terminal voltage at a plurality of time points within first set period Δs in a rest period after discharge.
Fig. 14 is a diagram illustrating an example of evaluating accuracy of an OCV predicted value based on a prediction error of a plurality of first set periods Δs in a rest period after discharge.
Fig. 15 is a diagram illustrating an image of feedback of each prediction error to a model during a rest period after discharge.
Fig. 16 is a diagram illustrating an example of transition of a measured value and a predicted value for a terminal voltage relaxation process during a rest period after discharge.

### DESCRIPTION OF EMBODIMENT

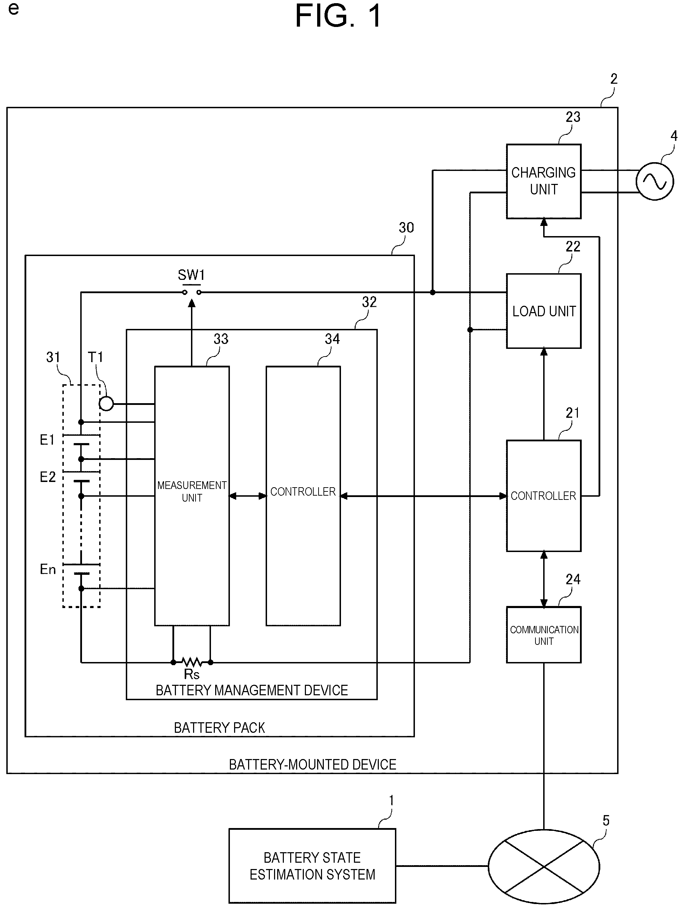

Fig. 1 is a diagram for explaining battery-mounted device 2 according to an exemplary embodiment. Battery-mounted device 2 according to the exemplary embodiment is a device on which chargeable and dischargeable battery pack 30 is mounted. Examples of battery-mounted device 2 include information devices for consumer use (for example, a PC, a tablet, or a smartphone), home electric appliances (for example, a cleaning robot), electric vehicles, electric motorcycles, electric bicycles, electric kick scooters, and multi-copters (drones). Hereinafter, in the present exemplary embodiment, a notebook PC is assumed.

Battery-mounted device 2 includes controller 21, load unit 22, charging unit 23, communication unit 24, and battery pack 30. Controller 21 integrally controls entire battery-mounted device 2. Functions of controller 21 can be achieved by cooperation of a hardware resource and a software resource, or by a hardware resource alone. Available examples of the hardware resource include a CPU, a ROM, a RAM, a graphics processing unit (GPU), an application specific integrated circuit (ASIC), a field programmable gate array (FPGA), and other LSI circuits. Available examples of the software resource include a program, such as an operating system or an application.

Load unit 22 is a general term (controller 21, charging unit 23, and communication unit 24 are excluded) for members that consume power in battery-mounted device 2. Charging unit 23 is connected to commercial power system 4 via an AC adapter (not illustrated). The AC adapter converts an AC voltage of 100/200 V input from commercial power system 4 into a DC voltage of about 5 V to 20 V, and outputs the DC voltage.

Charging unit 60 includes a DC/DC converter. The DC/DC converter (for example, a switching regulator) controls a current or a voltage of a DC power supplied from AC adapter according to a current command value or a voltage command value supplied from controller 21, and outputs the DC power of the current or the voltage specified by the command value to at least one of load unit 22 or battery pack 30.

Battery pack 30 includes assembled battery 31 and battery management device 32. Assembled battery 31 includes a plurality of cells E1 to En connected in series. The number of cells in series is determined by the specification of load unit 22. Available examples of the cell include a lithium-ion battery cell, a nickel-metal-hydride battery cell, and a lead battery cell. Hereinafter, the present description assumes an example of use of lithium ion battery cells (nominal voltage: 3.6 V to 3.7 V). At each series stage of cells, a plurality of cells may be connected in parallel in order to increase the capacity.

Switch SW1 for switching conduction/non-conduction with load unit 22 or charging unit 23 is inserted into a power line connecting assembled battery 31 and load unit 22 or charging unit 23. A semiconductor switch or a relay can be used as switch SW1.

Battery management device 32 includes measurement unit 33 and controller 34. Measurement unit 33 includes an analog front end (AFE) IC or an application specific integrated circuit (ASIC). Controller 34 includes a microcontroller.

Measurement unit 33 is connected to each node of the plurality of series-connected cells E1 to En with a plurality of voltage measurement lines and measures a voltage of each of cells E1 to En by measuring each voltage between two adjacent voltage lines.

Measurement unit 33 includes a multiplexer and an A/D converter. The multiplexer outputs respective voltages of the plurality of cells E1 to En to the A/D converter in a predetermined order. The A/D converter converts, into a digital value, an analog voltage to be input from the multiplexer. Measurement unit 33 transmits the voltage value of each of cells E1 to En converted into the digital value to controller 34 via a serial communication interface.

Measurement unit 33 measures the current flowing through assembled battery 31. Shunt resistor Rs is connected to a power line connecting assembled battery 31 and load unit 22 or charging unit 23. The differential amplifier (not illustrated) amplifies the voltage across shunt resistor Rs and outputs the amplified voltage to the A/D converter in measurement unit 33. The A/D converter converts an analog voltage, which is input from the differential amplifier and indicates a current flowing through assembled battery 31, into a digital value. Measurement unit 33 transmits the current value converted into the digital value to controller 34 via the serial communication interface.

Temperature sensor T1 (for example, a thermistor) is installed on the surface of assembled battery 31. A divided voltage of temperature sensor T1 and a voltage-dividing resistor (not illustrated) is input to measurement unit 33. The A/D converter in measurement unit 33 converts an analog voltage indicating an input temperature into a digital value. Measurement unit 33 transmits the temperature value converted into the digital value to controller 34 via the serial communication interface.

Controller 34 manages the states of cells E1 to En based on the voltage value of each of cells E1 to En, the current value flowing through assembled battery 31, and the temperature value of assembled battery 31 received from measurement unit 33. When detecting any one of overcharging, overdischarging, overcurrent, high-temperature fault, and low-temperature fault, controller 34 transmits a shut-off signal of switch SW1 to measurement unit 33 to turn off switch SW1.

Controller 34 implements the following functions by executing a program such as firmware in the microcontroller. Controller 34 estimates the SOC by combining an OCV method and a current integration method. The OCV method is a method of estimating the SOC based on the OCV of a cell to be measured and the SOC-OCV curve of the cell. The SOC-OCV curve of the cell is created in advance based on a characteristic test performed by a battery manufacturer, and is registered in controller 34 at the time of shipment.

The current integration method is a method of estimating the SOC based on the OCV at the start of charge and discharge of a cell and an integration value of a measured current. The current integration method causes a measurement error of the current to accumulate as charging and discharging time increases. Thus, it is preferable to use a weighted average of the SOC estimated by the current integration method and the SOC estimated by the OCV method.

Controller 34 transmits battery data including each cell voltage, current, temperature, and SOC of battery pack 30 to controller 21 via a network inside the device. Communication unit 24 is an external communication interface (for example, NIC: network interface card) for connection to external network 5 in a wired manner or a wireless manner. Controller 21 accesses network 5 via communication unit 24, and transmits the battery data received from controller 34 of battery pack 30 to battery state estimation system 1 at a predetermined transmission cycle (for example, cycle of 10 seconds).

Network 5 is a general term for communication paths such as the Internet, a dedicated line, and a virtual private network (VPN), and the communication medium and the protocol thereof are not limited. Available examples of the communication medium include a wired LAN, a wireless LAN, a cellular phone network, an optical fiber network, an ADSL network, and a CATV network. Available examples of the communication protocol include Transmission Control Protocol (TCP)/Internet Protocol (IP), user datagram protocol (UDP)/IP, and Ethernet (registered trademark).

Battery state estimation system 1 is a system for estimating and analyzing the state of battery pack 30 mounted on battery-mounted device 2. In the present exemplary embodiment, battery state estimation system 1 is constructed on a cloud server installed in a data center managed by a cloud service provider. A battery analysis service provider that provides a service for analyzing battery pack 30 uses the cloud server by contracting with the cloud service provider. Battery state estimation system 1 may be constructed on an own server installed in an own facility or a data center of the battery analysis service provider.

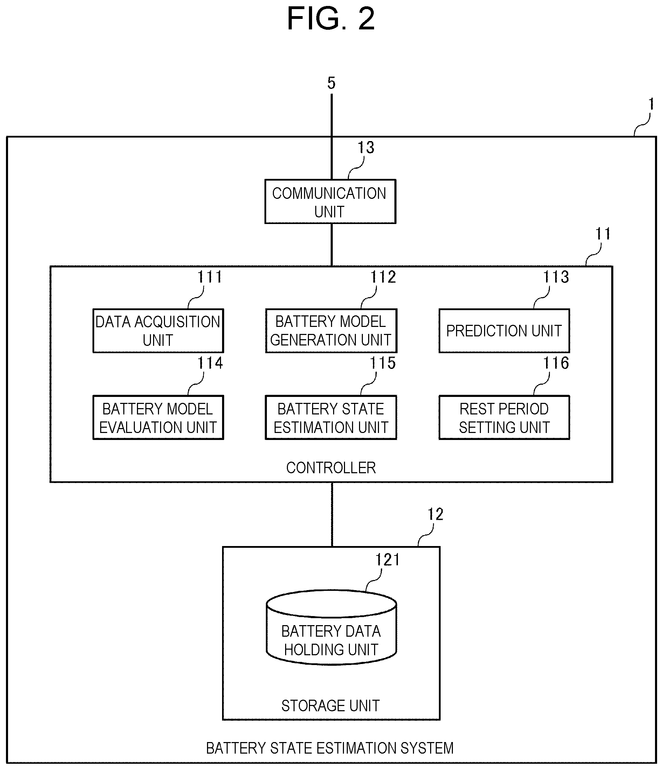

Fig. 2 is a diagram illustrating a configuration example of battery state estimation system 1 according to the exemplary embodiment. Battery state estimation system 1 includes controller 11, storage unit 12, and communication unit 13. Communication unit 13 is an external communication interface for connection to network 5 in a wired or wireless manner.

Controller 11 includes data acquisition unit 111, battery model generation unit 112, prediction unit 113, battery model evaluation unit 114, battery state estimation unit 115, and rest period setting unit 116. Functions of controller 11 can be achieved by cooperation of a hardware resource and a software resource, or by a hardware resource alone. As the hardware resources, a CPU, a ROM, a RAM, a GPU, an ASIC, an FPGA, and other LSIs can be used. Available examples of the software resource include a program, such as an operating system or an application.

Controller 11 is a microcomputer mainly including a central processing unit (CPU) and a memory, for example. In other words, controller 11 is implemented by a computer including the CPU and the memory. The CPU executes a program stored in the memory, allowing the computer to function as controller 11. In this example, the program is recorded in advance in the memory of controller 11. Alternatively, the program may be provided via a telecommunication line such as the Internet or by being recorded in a (non-transitory) recording medium such as a memory card.

Storage unit 12 includes a nonvolatile recording medium such as an HDD or an SSD, and stores various kinds of data. Storage unit 12 includes battery data holding unit 121. Data acquisition unit 111 acquires the battery data of battery pack 30 mounted on battery-mounted device 2 from battery-mounted device 2 via network 5. Data acquisition unit 111 stores the acquired battery data in battery data holding unit 121.

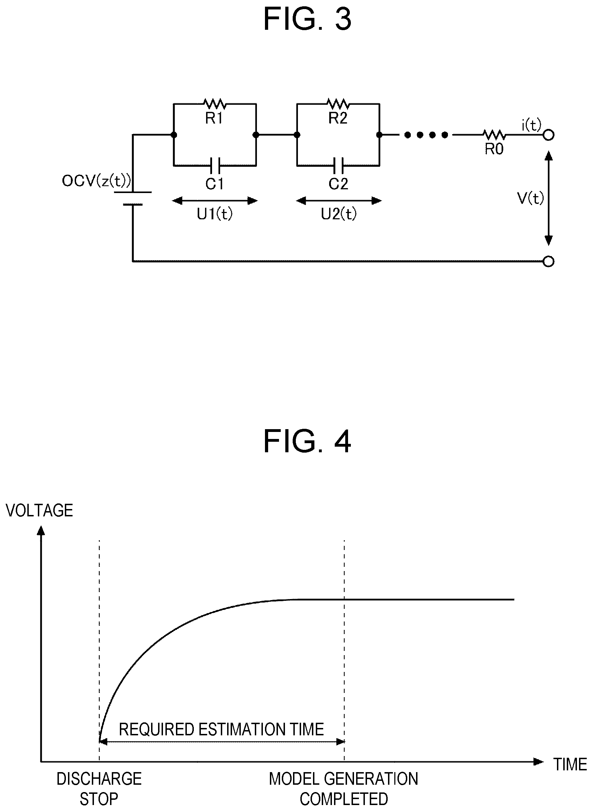

Fig. 3 is a diagram illustrating an example of an equivalent circuit model of each cell constituting assembled battery 31 in battery pack 30. A cell can be described by a voltage source, a plurality of RC parallel circuits, and a series circuit of resistors as shown in the following (Equation 1). The voltage source has a non-linear characteristic depending on SOC or temperature, and its output voltage is OCV. In the following (Equation 1), a voltage source that depends only on the SOC is described, but the voltage source may also depend on the temperature.$v \left(t\right) = OCV \left(z\left(t\right)\right) - {U}_{1} \left(t\right) - {U}_{2} - … {R}_{0} i \left(t\right)$
v(t) is a terminal voltage, i(t) is a terminal current, and z(t) is an SOC. ${U}_{j} \left(t\right) = {R}_{j} {I}_{Rj} \left(t\right)$ $i \left(t\right) = {iR}_{j} \left(t\right) + {C}_{j} ⋅ {dU}_{j} \left(t\right) / dt$
j is a natural number.
iRⱼ(t) can be expressed as the following (Equation 2) in a discrete formula.
${iR}_{j} \left(k+1\right) = exp \left(-Δt/{τ}_{j}\right) ⋅ {iR}_{j} \left(k\right) + \left(1-exp\left(-Δt/{τ}_{j}\right)⋅i\left(k\right.\right)$ $if i \left(t\right) = const . for kΔt \leq t \leq \left(k+1\right) Δt$ k denotes a sampling timing. ${τ}_{j} = {R}_{j} {C}_{j}$

The above (Equation 1) is an equivalent circuit model in a case where a current flows in a cell, and an equivalent circuit model of a cell in a state where no current flows can be described by the following (Equation 3).$CCV \left(t\right) = OCV - {V}_{1} ⋅ exp \left(-t/{τ}_{1}\right) - {V}_{2} ⋅ exp \left(-t/{τ}_{2}\right) - … - {V}_{n} ⋅ exp \left(-t/{τ}_{n}\right)$

CCV (Closed Circuit Voltage) is a terminal voltage.

Battery model generation unit 112 of battery state estimation system 1 generates an internal model of each cell based on measured values of the terminal voltages of cells E1 to En at a plurality of time points during a rest period after charge and discharge of battery pack 30. In the present exemplary embodiment, the internal model of the cell is generated using only the terminal voltage during the rest period without using the terminal voltage during the charge/discharge period. Hereinafter, an example is assumed in which battery model generation unit 112 generates the equivalent circuit model shown in (Equation 3) above during the rest period after discharge. The equivalent circuit model shown in (Equation 3) above can be used as a model for predicting the relaxation progress of the terminal voltage after discharge.

In a general cell, it often takes about several hours for the terminal voltage to stabilize after charge and discharge is stopped. In the present exemplary embodiment, the OCV of the cell is estimated by predicting the terminal voltage of the cell after stabilization before the terminal voltage of the cell is stabilized using the equivalent circuit model.

Fig. 4 is a diagram illustrating a transition image of a terminal voltage of a cell during a rest period after a discharge stop. The period from the time of stopping discharge to the completion of generation of the highly accurate battery model is a required estimation time for the OCV. In the present exemplary embodiment, the OCV estimation method achieving both convenience and accuracy is realized by variably setting the required estimation time and optimizing the required estimation time for the OCV.

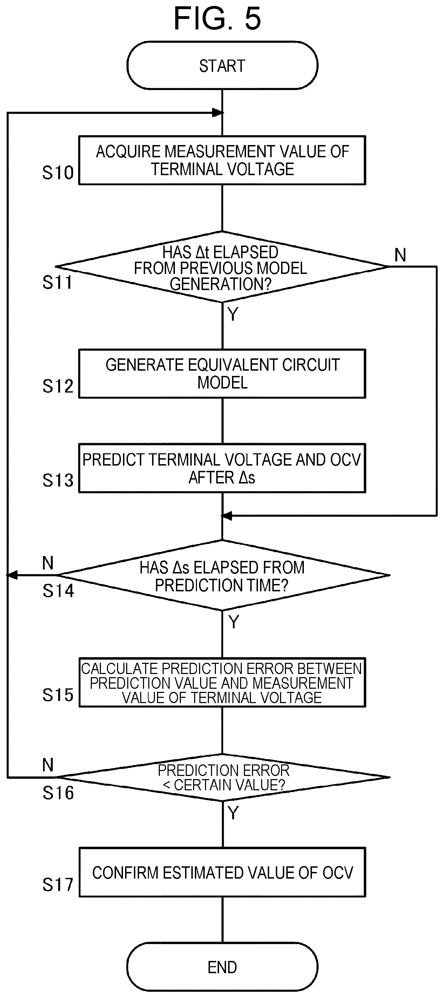

Fig. 5 is a flowchart illustrating a flow of OCV estimation processing performed by battery state estimation system 1 according to the exemplary embodiment. Data acquisition unit 111 acquires the measured value of the terminal voltage of each cell included in battery pack 30 from battery-mounted device 2 on which battery pack 30 is mounted via network 5 at a predetermined cycle (for example, cycle of 10 seconds) (S10).

Battery model generation unit 112 determines whether second set period Δt has elapsed from the time of the previous equivalent circuit model generation (S11). In the initial case, it is determined whether second set period Δt has elapsed from the time of stopping charge and discharge. Δt may be set, for example, at intervals of five minutes.

In a case where second set period Δt has elapsed (Y in S11), battery model generation unit 112 fits the measured values of the terminal voltages of the cells at the plurality of time points acquired from the start of the rest period to the present to generate an equivalent circuit model of the cell (S12). For example, the measured value of the terminal voltage at each time is substituted into the CCV(t) of the above (Equation 3), and the OCV, each polarization voltage Vⱼ, and each time constant τⱼ of the above (Equation 3) are identified using a trust-region-reflective algorithm.

Prediction unit 113 predicts the terminal voltage and the OCV of the cell after first set period Δs by using the equivalent circuit model of which the parameter is identified by battery model generation unit 112 (S13). The process proceeds to step S14. Although details will be described later, first set period Δs may be set to be shorter than, longer than, or equal to second set period Δt.

In step S11, in a case where second set period Δt has not elapsed from the time of the previous equivalent circuit model generation (N in S11), steps S12 and S13 are skipped. Battery model evaluation unit 114 determines whether first set period Δs has elapsed from the time of previous prediction of the terminal voltage and the OCV of the cell (S14). In a case where first set period Δs has not elapsed (N in S14), the process proceeds to step S10.

In a case where first set period Δs has elapsed (Y in S14), battery model evaluation unit 114 calculates a difference between the predicted value of the terminal voltage of the cell predicted before first set period Δs and the measured value of the terminal voltage actually measured at the present time as a prediction error (S15). The prediction error is obtained by an absolute value or a squared value.

Battery model evaluation unit 114 compares the prediction error with a certain value (S16). The certain value is set, for example, as a threshold for determining whether it is within an error range of ±3 mV or ±5 mV. In a case where the prediction error is equal to or larger than the certain value (N in S16), the process proceeds to step S10. In a case where the prediction error is less than the certain value (Y in S16), battery state estimation unit 115 determines the OCV of the cell predicted before first set period Δs as the estimated value of the OCV of the cell (S17).

Rest period setting unit 116 can forcibly set the rest period and cause the OCV estimation processing to be executed during the rest period. Note that if the time from the timing of the previous OCV estimation processing to the present is less than a certain value, rest period setting unit 116 prioritizes convenience and skips setting of a forced rest period.

For example, in a case where the user performs the charging operation on battery pack 30 at the timing when a certain period of time or more has elapsed from the timing at which the OCV is estimated last time, rest period setting unit 116 can forcibly set the rest period before charge. The setting of the forced rest period is effective for battery-mounted device 2 such as a PC used by a heavy user.

Note that the OCV estimation processing according to the present exemplary embodiment also contributes to shortening the OCV estimation time during the rest period in battery-mounted device 2 such as an EV in which the rest period is likely to occur naturally, and contributes to advancing the execution timing of another processing or control after the OCV estimation processing.

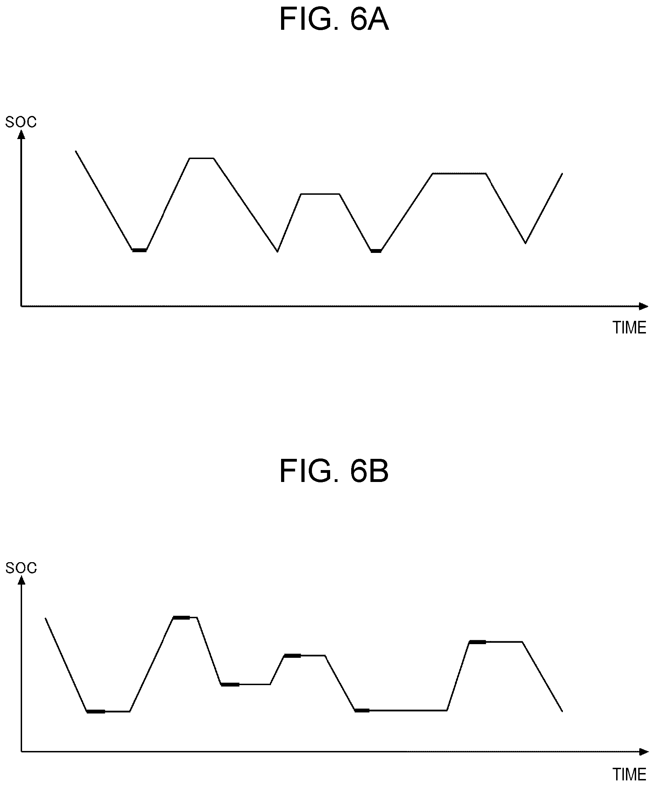

Figs. 6A and 6B are diagrams illustrating a transition example of the SOC of battery pack 30 mounted in battery-mounted device 2. The bold line indicates the OCV estimation time. Fig. 6A illustrates an SOC transition example of battery-mounted device 2 in which the rest period rarely occurs naturally, and rest period setting unit 116 forcibly sets the rest period and ends the rest period at a timing when the OCV can be estimated with high accuracy. Fig. 6B illustrates an SOC transition example of battery-mounted device 2 in which the rest period is likely to occur naturally. An OCV estimation time during a naturally occurring rest period is shortened compared to the related art.

Rest period setting unit 116 sets an upper limit to the rest period in order to avoid the OCV estimation processing from continuing indefinitely. As shown in step S16 of Fig. 5, in a case where the prediction error is equal to or larger than a certain value (N in S16), the OCV estimation processing is repeated, but in a case where the rest period has reached the upper limit, rest period setting unit 116 forcibly ends the OCV estimation processing. The same applies to a naturally occurring rest period. In this case, the OCV is not estimated in the current rest period, and the latest OCV is estimated in the next or subsequent rest period.

Battery model generation unit 112 may set second set period Δt to be constant or variable. In the case of variable setting, battery model generation unit 112 sets second set period Δt to be longer as it is closer to the start of the rest period.

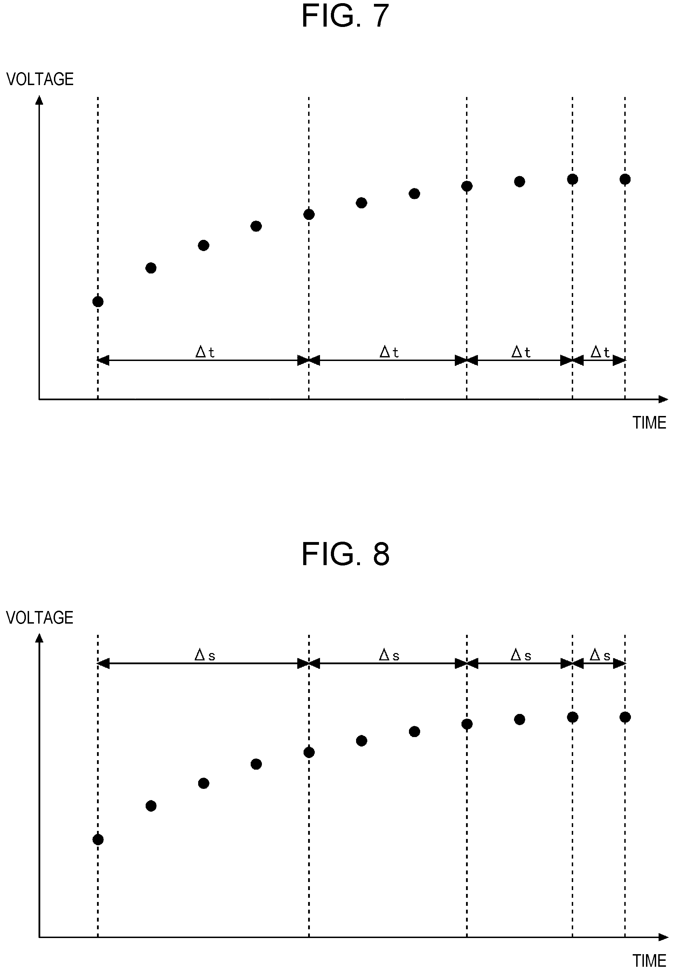

Fig. 7 is a diagram illustrating an example setting of second set period Δt during a rest period after discharge. At the beginning of the rest period, the number of data points of the terminal voltage is small, and it is difficult to generate a model. At least the number of data points larger than the number of parameters to be identified in the model is required. Even after the number of data points larger than the number of parameters to be identified is collected, the prediction accuracy of the model is low when the number of data points is small. As illustrated in Fig. 7, in the initial stage of the rest period in which the prediction accuracy of the model is low, it is desirable to reduce the generation frequency of the model to reduce the processing cost, and to increase the generation frequency of the model as time passes.

Prediction unit 113 may set first set period Δs to be constant or variable. In the case of variable setting, prediction unit 113 sets first set period Δs to be longer as it approaches the start of the rest period.

Fig. 8 is a diagram illustrating an example setting of first set period Δs during a rest period after discharge. At the beginning of the rest period, the voltage relaxation is large, and the prediction accuracy of the OCV is low. As illustrated in Fig. 8, in the initial stage of the rest period in which the OCV prediction accuracy is low, it is desirable to set first set period Δs to be long and to shorten first set period Δs as time elapses.

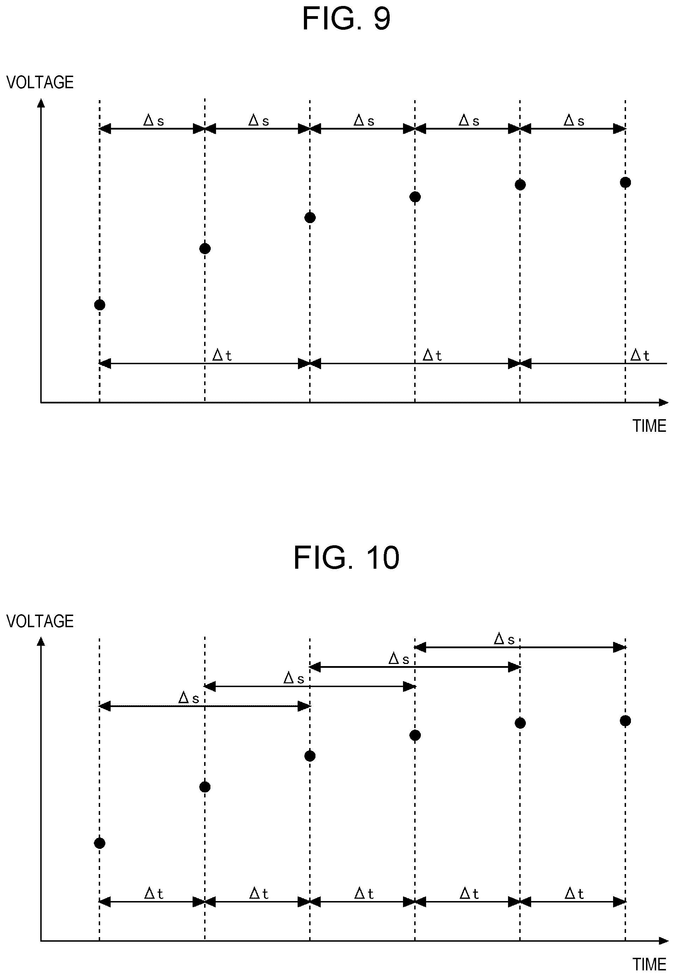

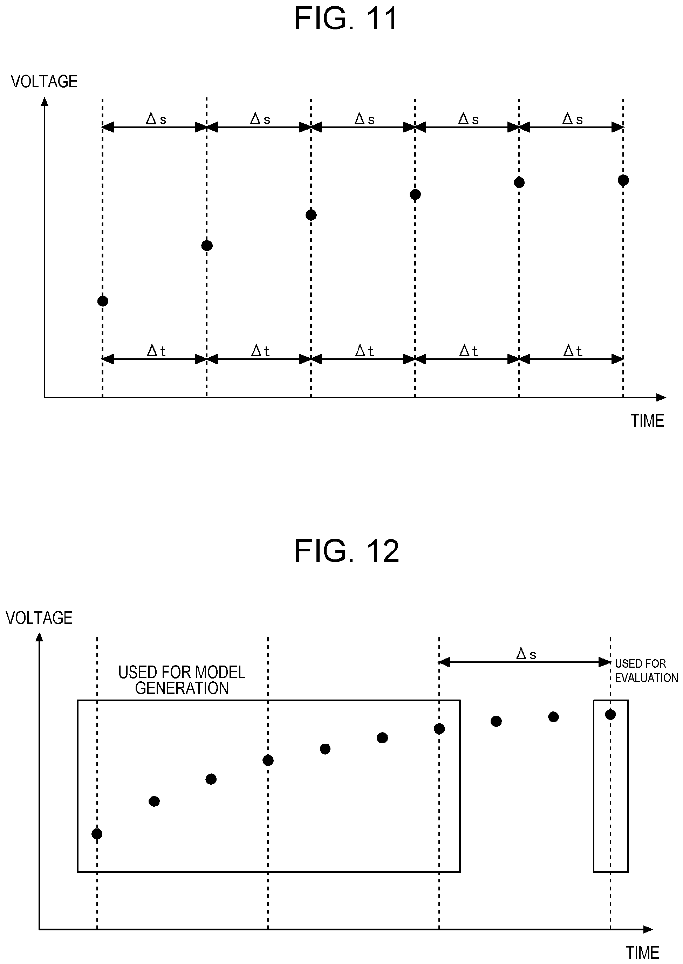

Fig. 9 is a diagram illustrating an example in which first set period Δs is set shorter than second set period Δt during a rest period after discharge. Fig. 10 is a diagram illustrating an example in which first set period Δs is set to be longer than second set period Δt during the rest period after discharge. Fig. 11 is a diagram illustrating an example in which first set period Δs and second set period Δt are set equal during a rest period after discharge.

In a case where the calculation cost is desired to be lowered, second set period Δt is set to be longer than first set period Δs as illustrated in Fig. 9 to lower the generation frequency of the model. In a case where it is desired to improve the reliability by evaluating the prediction error in many models, second set period Δt is set to be shorter than first set period Δs as illustrated in Fig. 10, and the generation frequency of the model is increased. In a case where it is desired to end the OCV estimation processing as soon as possible, second set period Δt and first set period Δs are set to be equal as illustrated in Fig. 11.

Prediction unit 113 may predict only the terminal voltage and the OCV at the final point within first set period Δs, or may predict the terminal voltage and the OCV at a plurality of time points. In the latter case, when the evaluation value based on the prediction error between the predicted value and the measured value of the terminal voltage at a plurality of time points is less than a certain value within first set period Δs, battery state estimation unit 115 determines the OCV predicted from the internal model of the cell as the estimated value of the OCV of the cell. For example, in a case where the average value or the median value of the prediction errors at a plurality of time points is less than a certain value, prediction unit 113 determines the OCV predicted from the internal model of the cell as the estimated value of the OCV of the cell.

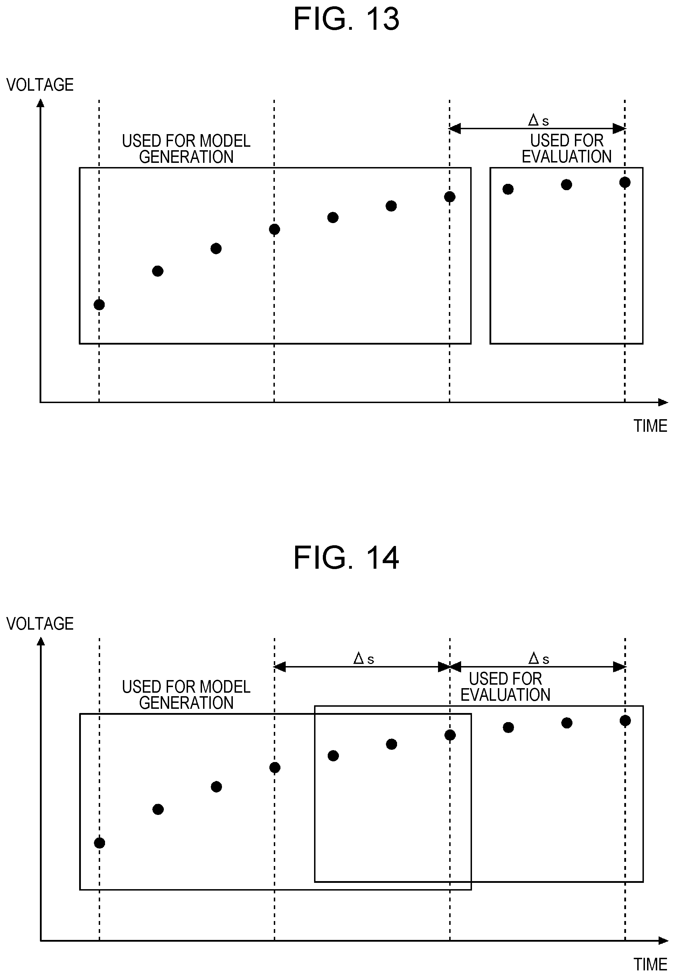

Fig. 12 is a diagram illustrating an example of evaluating the accuracy of the OCV predicted value based on the prediction error between the predicted value and the measured value of the terminal voltage at the final point within first set period Δs in the rest period after discharge. Fig. 13 is a diagram illustrating an example of evaluating the accuracy of the OCV predicted value based on the prediction error between the predicted values and the measured values of the terminal voltages at the plurality of time points within first set period Δs in the rest period after discharge. In the example illustrated in Fig. 12, the evaluation processing cost can be reduced. In the example illustrated in Fig. 13, the evaluation accuracy of the OCV predicted value can be improved.

In a case where the error between the predicted value and the measured value of the terminal voltage within first set period Δs is less than a certain value in the plurality of successive internal models, battery state estimation unit 115 may determine the estimated value of the OCV of the cell based on the OCV predicted from the plurality of internal models of the cell. For example, battery state estimation unit 115 may determine the OCV predicted from the internal model generated last among the plurality of internal models as the estimated value of the OCV of the cell. In addition, battery state estimation unit 115 may determine the average value or the median value of the plurality of OCVs predicted from the plurality of internal models as the estimated value of the OCV of the cell.

Fig. 14 is a diagram illustrating an example of evaluating the accuracy of the OCV predicted value based on prediction errors across the plurality of first set periods Δs in the rest period after discharge. In the example illustrated in Fig. 14, if the prediction error is less than a certain value in two consecutive evaluations, the OCV estimation processing ends. As a result, it is possible to prevent an estimated value of the OCV of a model with good accuracy by chance from being adopted.

Battery model generation unit 112 may update the initial value of the parameter of the equivalent circuit model to be generated next time based on the prediction error between the predicted value and the measured value of the terminal voltage in the equivalent circuit model generated this time. That is, the evaluation of the equivalent circuit model generated this time is fed back to the equivalent circuit model to be generated next time.

In a case where the predicted value of the terminal voltage of the equivalent circuit model generated this time is smaller than the measured value, battery model generation unit 112 increases the OCV of the equivalent circuit model and decreases the initial value of the polarization voltage, increases the time constant in the case of rest after discharge, and decreases the time constant in the case of rest after charge. Battery model generation unit 112 uses the value as an initial value of an internal model to be generated next time. Conversely, in a case where the predicted value of the terminal voltage of the equivalent circuit model generated this time is larger than the measured value, battery model generation unit 112 decreases the OCV and increases the initial value of the polarization voltage, decreases the time constant in the case of rest after discharge, and increases the time constant in the case of rest after charge. Battery model generation unit 112 uses the value as an initial value of an equivalent circuit model to be generated next time. The amount of change in the initial value of the time constant or the polarization voltage is determined according to the magnitude of the absolute value of the prediction error.

Hereinafter, an example of evaluating the nth-order Thevenin Model expressed in (Equation 3) above with a squared error will be described. When the gradient descent algorithm is applied, the parameter is updated as in the following (Equation 4).$Param = Param - α \left(\partial {\left({CCV}_{prd}-{CCV}_{act}\right)}^{2}/\partial Param\right)$

CCV_{prd} is a predicted value of the terminal voltage, CCV_{act} is a measured value of the terminal voltage, and α is a constant.

The OCV in the above (Equation 3) is updated to a value obtained by the following (Equation 5) in an equivalent circuit model to be generated next time.$OCV = OCV - 2 α \left({CCV}_{prd}-{CCV}_{act}\right)$

Polarization voltage Vⱼ in the above (Equation 3) is updated to a value obtained by the following (Equation 6) in an equivalent circuit model to be generated next time.${V}_{j} = {V}_{j} + 2 α \left({CCV}_{prd}-{CCV}_{act}\right) ⋅ exp \left(-Δt/{τ}_{j}\right)$

The time constant τⱼ in the above (Equation 3) is updated to a value obtained by the following (Equation 7) in an equivalent circuit model to be generated next time.${τ}_{j} = {τ}_{j} - 2 α \left({CCV}_{prd}-{CCV}_{act}\right) {V}_{j} ⋅ exp \left(-Δt/{τ}_{j}\right) ⋅ t / {{τ}_{j}}^{2}$

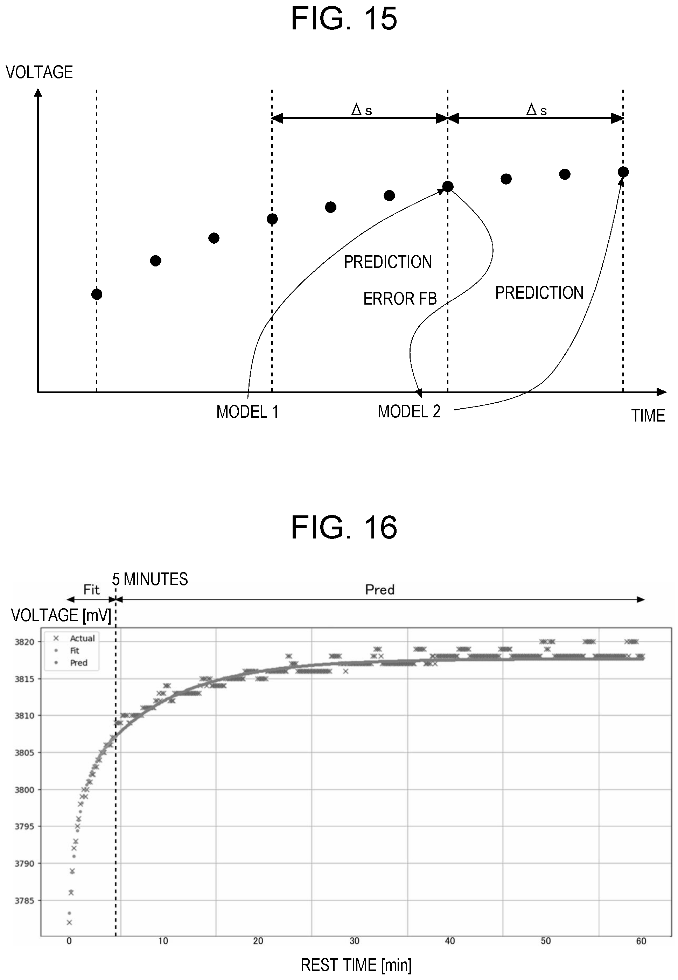

Fig. 15 is a diagram illustrating an image of feedback of each prediction error to the model during the rest period after discharge. The prediction error between the predicted value and the measured value of the terminal voltage measured by model 1 is reflected in the initial value of the parameter of model 2.

Fig. 16 is a diagram illustrating an example of transition of a measured value and a predicted value in a relaxation process of the terminal voltage during a rest period after discharge. Fig. 16 illustrates a prediction result by the equivalent circuit model of the above (Equation 3) generated from the measured value of the terminal voltage for 5 minutes from the start of rest. A cross mark indicates a measured value of the terminal voltage, and the measured value of the terminal voltage after 5 minutes from the start of rest can be predicted with high accuracy by the equivalent circuit model generated at the time of 5 minutes from the start of rest. If the measured value of the terminal voltage can be predicted with high accuracy, the OCV can also be estimated with high accuracy.

Battery state estimation unit 115 estimates the SOC of the cell based on the OCV of the cell estimated by the OCV estimation processing and the SOC-OCV curve of the cell. The SOC-OCV curve of the cell may be acquired from battery-mounted device 2, or may be estimated by acquiring the OCV and the SOC of the plurality of battery packs 30 of the same model.

Battery state estimation unit 115 estimates FCC based on depth of discharge DOD and integrated current value ΣI as expressed in following (Equation 7). Depth of discharge DOD is obtained by a difference between the SOC at the start of charge or discharge and the SOC at the end of charge or discharge. Current integration value ΣI is obtained by integrating measured values of the current during the charge or discharge period.$FCC = ΣI / DOD$

Battery state estimation unit 115 estimates an SOH based on the estimated FCC and an initial FCC as expressed in the following (Equation 8). The SOH is defined as a ratio of a current FCC to the initial FCC, and a lower value (closer to 0%) indicates that deterioration has progressed more.$SOH = Current FCC / Initial FCC$

In the experiment by the present inventor, the SOH based on the OCV estimated by the equivalent circuit model based on the measured value acquired during the rest period of 5 minutes after discharge yielded a result equivalent to the SOH based on the OCV estimated by the equivalent circuit model based on the measured value acquired during the rest period of 60 minutes after discharge. It can be said that the OCV estimated by the equivalent circuit model based on the measured value acquired during the rest period of 60 minutes after discharge is a value close to the true value, and the OCV estimated by the equivalent circuit model based on the measured value acquired during the rest period of 5 minutes after discharge is also a value close to the true value.

Each SOH based on each OCV estimated by the equivalent circuit model based on the measured values acquired during the rest period of 5 minutes after discharge, 15 minutes after discharge, and 30 minutes after discharge has been within an error of less than 1% with respect to the SOH based on the OCV estimated by the equivalent circuit model based on the measured values acquired during the rest period of 60 minutes after discharge. The SOH based on the OCV estimated by the equivalent circuit model based on the measured value acquired during the rest period of 1 minute after discharge has an error of 5% or more with respect to the SOH based on the OCV estimated by the equivalent circuit model based on the measured value acquired during the rest period of 60 minutes after discharge.

As described above, according to the present exemplary embodiment, by making the required estimation time for the OCV variable, the OCV estimation time can be shortened while ensuring a certain estimation accuracy. It is possible to estimate the OCV with high accuracy while minimizing a decrease in user convenience and a decrease in responsiveness of processing and control after the OCV estimation due to the setting of the OCV estimation time to be long. By identifying parameters of the equivalent circuit model, internal states other than the OCV, such as internal resistance and a time constant, can also be estimated.

The present disclosure has been described above based on the exemplary embodiment. It is to be understood by those skilled in the art that the exemplary embodiment is merely an example, that various modifications can be made by combining each component and each processing process of the exemplary embodiment, and that such modifications are also within the scope of the present disclosure.

In the above exemplary embodiment, the example in which the OCV is estimated by battery state estimation system 1 constructed in the cloud server has been described. In this regard, the function of the battery state estimation system may be implemented on the edge side. For example, the battery state estimation system may be mounted on battery management device 32 in battery pack 30, or the battery state estimation system may be mounted on controller 21 of battery-mounted device 2. In the case of mounting on the edge side, the OCV estimation time can be further shortened by shortening the acquisition interval of the measured value of the terminal voltage and increasing the number of data points.

In the above exemplary embodiment, an equivalent circuit model is assumed as an internal model of a battery for estimating OCV. In this regard, the OCV estimation may be performed based on an electrochemical model such as a Newman model as an internal model of the battery. When performing the OCV estimation with the Newman model described by the Poisson equation, the Butler-Volmer equation, the diffusion equation, and the Nernst-Planck equation, battery model generation unit 112 fits the measured values of the terminal voltages of the cells at a plurality of time points acquired from the start of the rest period to the present to the cell voltage equation represented by overvoltage, equilibrium potential, and liquid phase potential, and identifies parameters such as the initial value of the ion concentration. Prediction unit 113 predicts the future terminal voltage and the OCV of the cell using the Newman model in which the parameter is identified. Battery model evaluation unit 114 calculates, as a prediction error, a difference between the predicted value of the terminal voltage of the cell predicted and the measured value of the terminal voltage actually measured at the present time. Battery model evaluation unit 114 compares the prediction error with a certain value. Then, battery model generation unit 112 continues the parameter identification of the Newman model until the error therebetween becomes smaller than a predetermined threshold. In a case where the prediction error is less than the predetermined threshold, battery state estimation unit 115 may determine the predicted OCV of the cell as the estimated value of the OCV of the cell.

The exemplary embodiment may be specified by the following items.

### [Item 1]

A battery state estimation system (1) including:
a battery model generation unit (112) that generates an internal model of a battery (E1-En) including an open circuit voltage (OCV) based on measured values of a terminal voltage of the battery (E1-En) at a plurality of time points during a rest period after charge and discharge of the battery (E1-En);
a prediction unit (113) that predicts, based on the generated internal model of the battery (E1-En), a terminal voltage of the battery (E1-En) and an OCV of the battery (E1-En) at a time point after an elapse of a first set period from a time point of prediction; and
an OCV estimation unit (115) that determines the OCV predicted based on the internal model of the battery (E1-En) as an estimated value of the OCV of the battery (E1-En) in a case where an error between a predicted value and a measured value of a terminal voltage of the battery (E1-En) at the time point after the elapse of the first set period from the time point of the prediction is less than a certain value.

According to this, it is possible to shorten the OCV estimation time while securing a certain estimation accuracy.

### [Item 2]

The battery state estimation system (1) according to Item 1, wherein the battery model generation unit (112) generates the internal model of the battery (E1-En) at intervals of a second set period.

According to this, the estimation accuracy of the internal model can be improved over time.

### [Item 3]

The battery state estimation system (1) according to Item 1, further including:
a rest period setting unit (116) that forcibly sets the rest period before charge in a case where a charging operation is performed on the battery (E1-En) at a timing when a certain period of time or more has elapsed from a previously estimated timing of the OCV.

According to this, it is possible to estimate the OCV of the battery (E1-En) used in the usage method with a small rest period at an appropriate frequency.

### [Item 4]

The battery state estimation system (1) according to Item 2, in which the second set period is set to be longer as the second first set period is closer to a start of the rest period.

According to this, the processing cost can be reduced by reducing the generation frequency of the internal model in the initial stage of the rest period in which the estimation accuracy of the internal model is relatively low.

### [Item 5]

The battery state estimation system (1) according to Item 1, in which the first set period is set to be longer as the first set period is closer to a start of the rest period.

According to this, by setting the first setting period to be long in the initial stage of the rest period in which the voltage relaxation is large, the OCV prediction accuracy can be secured.

### [Item 6]

The battery state estimation system (1) according to Item 2, in which the second set period is set to be longer than the first set period.

According to this, the processing cost can be reduced by reducing the generation frequency of the internal model.

### [Item 7]

The battery state estimation system (1) according to Item 2, in which the second set period is set to be shorter than the first set period.

According to this, by increasing the prediction frequency of the terminal voltage and the OCV, the OCV estimation accuracy can be further improved.

### [Item 8]

The battery state estimation system (1) according to Item 2, in which a length of the second set period is set to be equal to a length of the first set period.

According to this, the OCV estimation processing can be ended as soon as possible.

### [Item 9]

The battery state estimation system (1) according to Item 1, in which
the prediction unit (113) predicts a terminal voltage and an OCV of the battery (E1-En) at a plurality of points within a first set period, and
the OCV estimation unit (115) determines an OCV predicted from an internal model of the battery (E1-En) as an estimated value of the OCV of the battery (E1-En) in a case where an evaluation value based on an error between a predicted value and a measured value of a terminal voltage of the battery (E1-En) at a plurality of time points is less than a certain value within the first set period.

According to this, the OCV estimation accuracy can be further improved.

### [Item 10]

The battery state estimation system (1) according to Item 2, in which the OCV estimation unit (115) determines an estimated value of the OCV of the battery (E1-En) based on the OCV predicted from a plurality of successive internal models in a case where an error between a predicted value and a measured value of the terminal voltage of the battery (E1-En) within the first set period is less than a certain value in the plurality of successive internal models.

According to this, the OCV estimation accuracy can be further improved.

### [Item 11]

The battery state estimation system (1) according to Item 2, in which the battery model generation unit (112) updates an initial value of a parameter of an internal model to be generated next time based on an error between a predicted value and a measured value of a terminal voltage of the battery (E1-En) in the internal model generated this time.

According to this, the estimation accuracy of the internal model can be improved over time.

### [Item 12]

A battery state estimation method including:
a step of generating an internal model of a battery (E1-En) including an open circuit voltage (OCV) based on measured values of a terminal voltage of the battery (E1-En) at a plurality of time points during a rest period after charge and discharge of the battery (E1-En);
a step of predicting a terminal voltage of the battery (E1-En) and an OCV of the battery (E1-En) at a first set period based on the generated internal model of the battery (E1-En); and
a step of determining an OCV predicted from the internal model of the battery (E1-En) as an estimated value of the OCV of the battery (E1-En) in a case where an error between a predicted value and a measured value of a terminal voltage of the battery (E1-En) at the first set period from a prediction time point is less than a certain value.

According to this, it is possible to shorten the OCV estimation time while securing a certain estimation accuracy.

### [Item 13]

A battery state estimation program for causing a computer to execute:
a process of generating an internal model of a battery (E1-En) including an open circuit voltage (OCV) based on measured values of a terminal voltage of the battery (E1-En) at a plurality of time points during a rest period after charge and discharge of the battery (E1-En);
a step of predicting a terminal voltage of the battery (E1-En) and an OCV of the battery (E1-En) at a first set period based on the generated internal model of the battery (E1-En); and
a process of determining an OCV predicted from the internal model of the battery (E1-En) as an estimated value of the OCV of the battery (E1-En) in a case where an error between a predicted value and a measured value of a terminal voltage of the battery (E1-En) at the first set period from a prediction time point is less than a certain value.

According to this, it is possible to shorten the OCV estimation time while securing a certain estimation accuracy.

### REFERENCE MARKS IN THE DRAWINGS

- 2: battery-mounted device
- 4: commercial power system
- 5: network
- 21: controller
- 22: load unit
- 23: charging unit
- 24: communication unit
- 30: battery pack
- 31: assembled battery
- 32: battery management device
- 33: measurement unit
- 34: controller
- E1-En: cell
- Rs: shunt resistor
- SW1: switch
- 1: battery state estimation system
- 11: controller
- 111: data acquisition unit
- 112: battery model generation unit
- 113: prediction unit
- 114: battery model evaluation unit
- 115: battery state estimation unit
- 116: rest period setting unit
- 12: storage unit
- 121: battery data holding unit
- 13: communication unit

## Claims

1. A battery state estimation system comprising:
a battery model generation unit that generates an internal model of a battery including an open circuit voltage (OCV) based on measured values of a terminal voltage of the battery at a plurality of time points during a rest period after charge and discharge of the battery;
a prediction unit that predicts, based on the generated internal model of the battery, a terminal voltage of the battery and an OCV of the battery at a time point after an elapse of a first set period from a time point of prediction; and
an OCV estimation unit that determines the OCV predicted based on the internal model of the battery as an estimated value of the OCV of the battery in a case where an error between a predicted value and a measured value of a terminal voltage of the battery at the time point after the elapse of the first set period from the time point of the prediction is less than a certain value.

2. The battery state estimation system according to Claim 1, wherein the battery model generation unit generates the internal model of the battery at intervals of a second set period.

3. The battery state estimation system according to Claim 1, further comprising:
a rest period setting unit that forcibly sets the rest period before charge in a case where a charging operation is performed on the battery at a timing when a certain period of time or more has elapsed from a previously estimated timing of the OCV.

4. The battery state estimation system according to Claim 2, wherein the second set period is set to be longer as the second set period is closer to a start of the rest period.

5. The battery state estimation system according to Claim 1, wherein the first set period is set to be longer as the first set period is closer to a start of the rest period.

6. The battery state estimation system according to Claim 2, wherein the second set period is set to be longer than the first set period.

7. The battery state estimation system according to Claim 2, wherein the second set period is set to be shorter than the first set period.

8. The battery state estimation system according to Claim 2, wherein a length of the second set period is set to be equal to a length of the first set period.

9. The battery state estimation system according to Claim 1, wherein
the prediction unit predicts a terminal voltage and an OCV of the battery at a plurality of time points within a first set period, and
the OCV estimation unit determines an OCV predicted from an internal model of the battery as an estimated value of the OCV of the battery in a case where an evaluation value based on an error between a predicted value and a measured value of a terminal voltage of the battery at a plurality of time points is less than a certain value within the first set period.

10. The battery state estimation system according to Claim 2, wherein the OCV estimation unit determines an estimated value of the OCV of the battery based on the OCV predicted from a plurality of successive internal models in a case where an error between a predicted value and a measured value of the terminal voltage of the battery within the first set period is less than a certain value in the plurality of successive internal models.

11. The battery state estimation system according to Claim 2, wherein the battery model generation unit updates an initial value of a parameter of an internal model to be generated next time based on an error between a predicted value and a measured value of a terminal voltage of the battery in the internal model generated this time.

12. A battery state estimation method comprising:
a step of generating an internal model of a battery including an OCV based on measured values of a terminal voltage of the battery at a plurality of time points during a rest period after charge and discharge of the battery;
a step of predicting a terminal voltage of the battery and an OCV of the battery at a first set period based on the generated internal model of the battery; and
a step of determining an OCV predicted from the internal model of the battery as an estimated value of the OCV of the battery in a case where an error between a predicted value and a measured value of a terminal voltage of the battery at the first set period from a prediction time point is less than a certain value.

13. A battery state estimation program for causing a computer to execute:
a process of generating an internal model of a battery including an OCV based on measured values of a terminal voltage of the battery at a plurality of time points during a rest period after charge and discharge of the battery;
a step of predicting a terminal voltage of the battery and an OCV of the battery at a first set period based on the generated internal model of the battery; and
a process of determining an OCV predicted from the internal model of the battery as an estimated value of the OCV of the battery in a case where an error between a predicted value and a measured value of a terminal voltage of the battery at the first set period from a prediction time point is less than a certain value.

14. A non-transitory recording medium having stored therein the battery state estimation program according to Claim 13.
